# EUROPÄISCHE PATENTSCHRIFT

(11) **EP 2 676 147 B1**
(45) Veröffentlichungstag und Bekanntmachung des Hinweises auf die Patenterteilung: **05.10.2016**
(21) Anmeldenummer: 11805035.0
(22) Anmeldetag: 22.12.2011
(51) Int. Cl.: G01R 31/04, G01R 31/02

(54) **ANORDNUNG UND VERFAHREN ZUR VERBINDUNGSABRISSERKENNUNG AN EINEM SCHALTUNGSTEIL MIT KAPAZITIVEM VERHALTEN**
ARRANGEMENT AND METHOD FOR DETECTING CONNECTION LOSS AT A CIRCUIT PART HAVING A CAPACITIVE BEHAVIOUR
ENSEMBLE ET PROCÉDÉ DE DÉTECTION D'UNE COUPURE DE CONNEXION SUR UNE PARTIE DE CIRCUIT À COMPORTEMENT CAPACITIF

(30) Priorität: 17.02.2011 DE 102011004288
(43) Veröffentlichungstag der Anmeldung: 25.12.2013
(73) Patentinhaber: Robert Bosch GmbH, 70442 Stuttgart (DE)
(72) Erfinder: REIMANN, Mathias, 71254 Ditzingen (DE)
(86) Internationale Anmeldenummer: PCT/EP2011/073821
(87) Internationale Veröffentlichungsnummer: WO 2012/110152

(56) Entgegenhaltungen:
- EP-A1- 2 239 589
- DE-A1- 4 005 609
- DE-A1- 19 938 060
- DE-A1-102004 026 971
- US-A- 4 638 246
- US-A1- 2008 157 782

## Beschreibung

### Stand der Technik

Die Erfindung geht aus von einer Anordnung zur Verbindungsabrisserkennung an einem Schaltungsteil mit kapazitivem Verhalten nach der Gattung des unabhängigen Patentanspruchs 1 und von einem Verfahren zur Verbindungsabrisserkennung an einem Schaltungsteil mit kapazitivem Verhalten nach der Gattung des unabhängigen Patentanspruchs 6.

Bei bekannten Drehratensensoren für Kraftfahrzeuge sind sicherheitskritische Drahtbonds mit einer Überwachung versehen. Das Funktionsprinzip dahinter ist eine Stromquelle, welche einen geringen Messgleichstrom in den Bond einprägt, welcher über einen anderen Bond wieder zurückfließt. Bei Abriss bzw. Unterbrechung eines der beiden Bonds kann der Stromfluss nicht aufrecht erhalten werden und ein solcher Abriss bzw. eine solche Unterbrechung kann erkannt werden, indem beispielsweise ein Fehlerflag gesetzt wird, welches den Bondabriss bzw. die Bondunterbrechung signalisiert. Durch die beschriebene Bondabrisserkennung können jedoch Bonds, welche mit einem Schaltungsteil mit einem kapazitiven Verhalten verbunden sind, nicht überwacht werden, da kein Messgleichstrom eingeprägt werden kann. Deshalb können einige sicherheitsrelevante Bonds nicht überwacht werden.

In der Offenlegungsschrift DE 10 2004 026 971A1 wird beispielsweise ein mikromechanischer Sensor mit Fehlererkennung beschrieben. Der beschriebene Sensor umfasst einen mikromechanischen Funktionsteil und eine elektronische Auswerteschaltung, welche miteinander in elektrischer Verbindung stehen. Zudem sind Mittel zur Durchführung eines Selbsttests des Sensors derart vorgesehen, dass eine Fehlererkennung wenigstens einer elektrischen Verbindung realisiert ist. Während des Selbsttests sendet ein Anregungsmodul ein Signalmuster an das mikromechanische Funktionsteil. In der Folge entsteht ein Messsignal, welches von einem Signalauswertemodul in ein Sensorausgangssignal umgewandelt wird. Das Anregungsmodul stellt neben dem Testsignal auch ein Korrelationssignal bereit. Das Korrelationssignal und das Sensorausgangssignal werden einem Demodulationsmodul zur Verfügung gestellt, in welchem eine korrelierte Demodulation der Signale stattfindet. Ein demoduliertes Ausgangssignal wird einem Bewertungsmodul zur Verfügung gestellt, in welchem aufgrund des ausgewerteten Signalmusters schließlich der Zustand der wenigstens eine elektrische Verbindung bewertet und ein entsprechendes Signal ausgegeben wird.

Aus der DE 40 05 609 A1 sind ein Verfahren und eine Vorrichtung zur Funktionsüberwachung eines von einer Steuerschaltung angesteuerten elektrischen Verbrauchers bekannt, welcher ein induktives Verhalten aufweist. Hierbei werden Fehler des Verbrauchers durch einen Vergleich eines der Ansteuerung des Verbrauchers dienenden Nutzsignals und eines der Steuerschaltung über eine Auswerteschaltung zurückgeleitetes Rückmeldesignals erfasst. Durch eine logische Auswertung der Signale vor, während und nach einem Schaltereignis können ein Kurzschluss nach Masse bzw. zur Versorgungsspannung sowie ein Kabelabfall bzw. ein Verbindungsabriss festgestellt und unterschieden werden. Zu diesem Zweck umfasst die Auswerteschaltung einen Komparator und ein RC-Glied mit einem ohmschen Widerstand und einem Kondensator. Das RC-Glied ist mit einem Eingangsknoten des elektrischen Verbrauchers elektrisch verbunden und erzeugt aus dem, dem Verbraucher zugeleiteten Nutzsignal ein Eingabesignal für den Komparator, welcher das vom RC-Glied erzeugte Eingabesignal mit einem Referenzsignal vergleicht und das Rückmeldesignal an die Steuerschaltung ausgibt. Über das von dem RC-Glied erzeugte Eingabesignal und das an die Steuerschaltung übertragene Rückmeldesignal kann das Aufladeverhalten des Kondensators des RC-Glieds zur Erkennung eines Kabelabfalls bzw. eines Verbindungsabrisses ausgewertet werden.

Aus der EP 2 239 589 A1 sind eine Vorrichtung, ein Verfahren und eine Anordnung zur Integritätsprüfung einer elektrischen Verkabelung bekannt, welche mit ihren Enden an eine im Normalfall offene Vorrichtung angeschlossen ist. Die Vorrichtung umfasst einen Kondensator, welcher in einem montierten Zustand parallel zu der im Normalfall offenen Vorrichtung angeschlossen ist und eine Messvorrichtung, welche in einem montierten Zustand am anderen Ende der Verkabelung angeschlossen ist. Die Messvorrichtung umfasst Versorgungsmittel zum Bereitstellen einer elektrischen Versorgung, Entlademittel zum Entladen des Kondensators, Messmittel zum Messen wenigstens eines elektrischen Parameters, Umschaltmittel, um die Versorgungsmittel oder die Entlademittel mit der elektrischen Verkabelung zu verbinden, und Auswertemittel, welche die Integrität der Verkabelung basierend auf dem gemessenen elektrischen Parameter feststellt und anzeigt. Die Umschaltmittel sind eingerichtet, um die Messvorrichtung zwischen einem Ladezustand, in dem die Versorgungsmittel den Kondensator laden, und einem Entladezustand umzuschalten, in dem die Entlademittel den Kondensator entladen. Die Auswertemittel bestimmten die Integrität der Verkabelung in Abhängigkeit des Aufladeverhaltens des parallel zu der im Normalfall offenen Vorrichtung angeschlossenen Kondensators.

### Offenbarung der Erfindung

Die erfindungsgemäße Anordnung zur Verbindungsabrisserkennung an einem Schaltungsteil mit kapazitivem Verhalten mit den Merkmalen des unabhängigen Patentanspruchs 1 und das erfindungsgemäße Verfahren zur Verbindungsabrisserkennung an einem Schaltungsteil mit kapazitivem Verhalten mit den Merkmalen des unabhängigen Patentanspruchs 6 haben demgegenüber den Vorteil, dass ein ohnehin am Schaltungsteil mit kapazitivem Verhalten anliegendes gepulstes Nutzsignal erfasst und zur Verbindungsabrisserkennung ausgewertet wird. Dadurch kann in vorteilhafter Weise mit geringem Hardwareaufwand und ohne zusätzliche Signalgeneratoren zur Erzeugung von Testsignalen eine schnelle und sichere Verbindungsabrisserkennung durchgeführt und dadurch eine große Lücke zu einem sicheren Betrieb auf einfache Weise geschlossen werden.

Ausführungsformen der vorliegenden Erfindung nutzen in vorteilhafter Weise den Umstand aus, dass elektrische Verbindungsstellen zu Schaltungsteilen mit kapazitivem Verhalten einem Taktschema mit Auf- und Entladen unterliegen. Bei einer abgerissenen elektrischen Verbindung ändert sich das Aussehen der Entladekurven. Diese Veränderung kann bei der Überwachung des Eingangsknoten zu Schaltungsteilen mit kapazitivem Verhalten erkannt und ausgewertet werden.

Ausführungsformen der vorliegenden Erfindung stellen eine Anordnung zur Verbindungsabrisserkennung an einem Schaltungsteil mit kapazitivem Verhalten zur Verfügung, welches elektrisch mit einer Nutzsignalquelle verbunden ist. Erfindungsgemäß ist eine Auswerteschaltung vorgesehen, welche mit einem Eingangsknoten des Schaltungsteils mit kapazitivem Verhalten elektrisch verbunden ist und das von der Nutzsignalquelle ausgegebene gepulste Nutzsignal am Eingangsknoten des Schaltungsteils mit kapazitivem Verhalten erfasst und die Signalcharakteristik zur Verbindungsabrisserkennung auswertet. Zudem wertet die Auswerteschaltung als Signalcharakteristik eine Entladekurve des gepulsten Nutzsignals aus. Die Auswertung kann beispielsweise dadurch erfolgen, dass ein aktuell erfasster Spannungswert des gepulsten Nutzsignals mit einem Schwellwert verglichen wird.

Zudem stellen Ausführungsformen der vorliegenden Erfindung ein Verfahren zur Verbindungsabrisserkennung an einem Schaltungsteil mit kapazitivem Verhalten zur Verfügung, welches elektrisch mit einer Nutzsignalquelle verbunden ist. Erfindungsgemäß wird an einem Eingangsknoten des Schaltungsteils mit kapazitivem Verhalten das von der Nutzsignalquelle ausgegebene gepulste Nutzsignal erfasst und die Signalcharakteristik zur Verbindungsabrisserkennung ausgewertet. Zudem wird als Signalcharakteristik eine Entladekurve des gepulsten Nutzsignals ausgewertet.

Durch die in den abhängigen Ansprüchen aufgeführten Maßnahmen und Weiterbildungen sind vorteilhafte Verbesserungen der im unabhängigen Patentanspruch 1 angegebenen Anordnung zur Verbindungsabrisserkennung an einem Schaltungsteil mit kapazitivem Verhalten und des im unabhängigen Patentanspruch 6 angegebenen Verfahrens zur Verbindungsabrisserkennung an einem Schaltungsteil mit kapazitivem Verhalten möglich.

In vorteilhafter Ausgestaltung der erfindungsgemäßen Anordnung erkennt die Auswerteschaltung beispielsweise eine abgerissene elektrische Verbindung bzw. einen abgerissenen Drahtbond, wenn ein erfasster Spannungswert des gepulsten Nutzsignals zu einem Messzeitpunkt oberhalb eines vorgegebenen Schwellwerts liegt. Alternativ kann die Auswerteschaltung eine ordnungsgemäße elektrische Verbindung bzw. einen angeschlossenen Drahtbond erkennen, wenn der erfasste Spannungswert des gepulsten Nutzsignals zu einem Messzeitpunkt (TM) unterhalb des vorgegebenen Schwellwerts liegt.

In weiterer vorteilhafter Ausgestaltung der erfindungsgemäßen Anordnung wählt die Auswerteschaltung den Messzeitpunkt so, dass ungefähr 80 bis 95%, vorzugsweise 90% einer Impulsdauer eines korrespondierenden Auswerteimpulses des Nutzsignals abgelaufen sind, da zu diesem Zeitpunkt der korrespondierende Lade bzw. Entladevorgang des kapazitiven Anteils des Schaltungsteils im Wesentlichen abgeschlossen ist. Des Weiteren wird vorgeschlagen, dass die Auswerteschaltung das gepulste Nutzsignal fortlaufend, zu vorgebbaren Zeitpunkten und/oder zyklisch erfasst bzw. auswertet. Durch diese Maßnahmen kann der Auswertezeitpunkt optimal an das kapazitive Verhalten des zu überwachenden Schaltungsteils angepasst werden und in vorteilhafter Weise eine sichere Verbindungsabrisserkennung ermöglicht werden.

In vorteilhafter Ausgestaltung des erfindungsgemäßen Verfahrens wird eine abgerissene elektrische Verbindung erkannt, wenn ein erfasster Spannungswert des gepulsten Nutzsignals zu einem Messzeitpunkt oberhalb eines vorgegebenen Schwellwerts liegt, und wobei eine ordnungsgemäße elektrische Verbindung erkannt wird, wenn der erfasste Spannungswert des gepulsten Nutzsignals zu einem Messzeitpunkt unterhalb des vorgegebenen Schwellwerts liegt. Der Messzeitpunkt wird so gewählt, dass ungefähr 80 bis 95%, vorzugsweise 90% einer Impulsdauer eines korrespondierenden Auswerteimpulses des Nutzsignals abgelaufen sind, da zu diesem Zeitpunkt der korrespondierende Lade bzw. Entladevorgang des kapazitiven Anteils des Schaltungsteils im Wesentlichen abgeschlossen ist.

In weiterer vorteilhafter Ausgestaltung des erfindungsgemäßen Verfahrens wird das gepulste Nutzsignal fortlaufend, zu vorgebbaren Zeitpunkten und/oder zyklisch erfasst bzw. ausgewertet.

Ein Ausführungsbeispiel der Erfindung ist in den Zeichnungen dargestellt und wird in der nachfolgenden Beschreibung näher erläutert. In den Zeichnungen bezeichnen gleiche Bezugszeichen Komponenten bzw. Elemente, die gleiche bzw. analoge Funktionen ausführen.

Kurze Beschreibung der Zeichnungen
Fig. 1 zeigt ein schematisches Blockschaltbild eines Ausführungsbeispiels einer erfindungsgemäßen Anordnung zur Verbindungsabrisserkennung an Schaltungsteilen mit kapazitivem Verhalten mit einer ordnungsgemäßen elektrischen Verbindung.
Fig. 2 zeigt ein schematisches Blockschaltbild des Ausführungsbeispiels einer erfindungsgemäßen Anordnung zur Verbindungsabrisserkennung an Schaltungsteilen mit kapazitivem Verhalten mit einer aufgetrennten bzw. abgerissenen elektrischen Verbindung.
Fig. 3 zeigt eine gemeinsame schematische Darstellung des Verlaufs des Nutzsignals am Eingangsknoten des Schaltungsteils mit kapazitivem Verhalten bei einer ordnungsgemäßen elektrischen Verbindung und des Verlaufs des Nutzsignals am Eingangsknoten des Schaltungsteils mit kapazitivem Verhalten bei einer aufgetrennten bzw. abgerissenen elektrischen Verbindung sowie eine Darstellung eines konstanten Schwellwerts.
Fig. 4 zeigt eine Detaildarstellung aus Fig. 3.

### Ausführungsformen der Erfindung

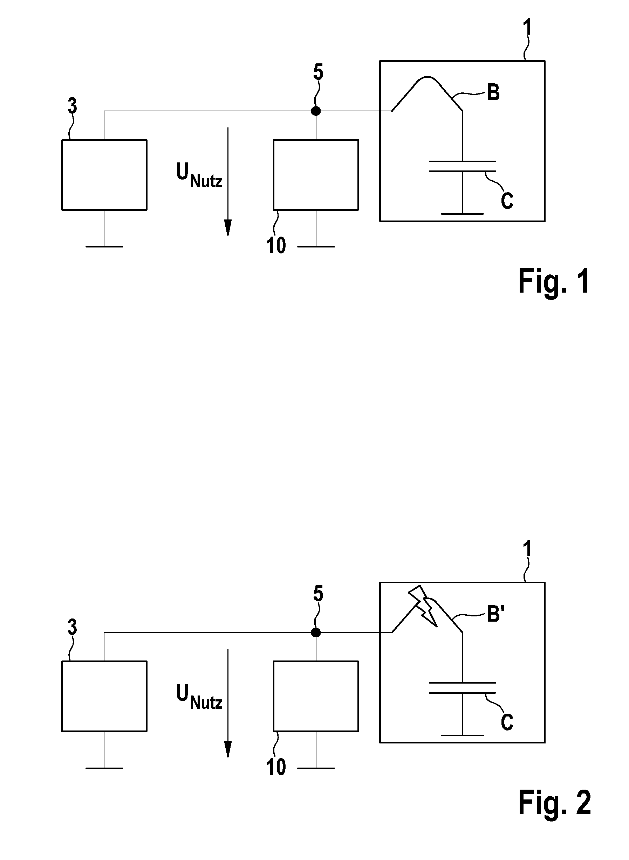

Wie aus Fig. 1 und 2 ersichtlich ist, umfasst das dargestellte Ausführungsbeispiel einer Anordnung zur Verbindungsabrisserkennung an einem Schaltungsteil 1 mit kapazitivem Verhalten, welches elektrisch mit einer Nutzsignalquelle 3 verbunden ist, erfindungsgemäß eine Auswerteschaltung 10. Die Auswerteschaltung 10 ist mit einem Eingangsknoten 5 des Schaltungsteils 1 mit kapazitivem Verhalten elektrisch verbunden und erfasst das von der Nutzsignalquelle 3 ausgegebene gepulste Nutzsignal U_{NUTZ} am Eingangsknoten 5 des Schaltungsteils 1 mit kapazitivem Verhalten. Des Weiteren wertet die Auswerteschaltung 10 die Signalcharakteristik zur Verbindungsabrisserkennung aus.

Wie aus Fig. 1 und 2 weiter ersichtlich ist, wird das kapazitive Verhalten des Schaltungsteils 1 durch einen Kondensator C repräsentiert und die elektrische Verbindung zwischen dem Eingangsknoten 5 und dem Kondensator wird durch einen Drahtbond B repräsentiert. Der Unterschied zwischen den Darstellungen aus Fig. 1 und 2 besteht darin, dass die Darstellung gemäß Fig. 1 das elektrische Schaltungsteil 1 mit einer ordnungsgemäßen elektrischen Verbindung B zeigt, und die Darstellung gemäß Fig. 2 das elektrische Schaltungsteil 1 mit einer durchtrennten bzw. abgerissenen elektrischen Verbindung B' zeigt.

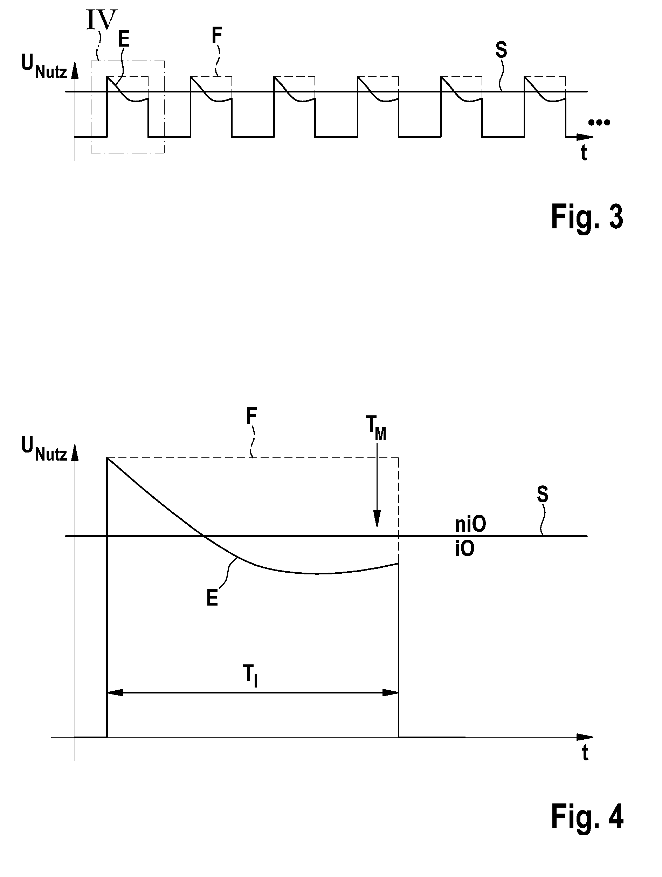

Fig. 3 zeigt eine gemeinsame schematische Darstellung des Verlaufs des Nutzsignals U_{NUTZ} am Eingangsknoten 5 des Schaltungsteils 1 mit kapazitivem Verhalten bei einer ordnungsgemäßen elektrischen Verbindung B und des Verlaufs des Nutzsignals U_{NUTZ} am Eingangsknoten 5 des Schaltungsteils 1 mit kapazitivem Verhalten bei einer aufgetrennten bzw. abgerissenen elektrischen Verbindung B' sowie einen konstanten Schwellwert S. Fig. 4 zeigt einen Impuls des Nutzsignal U_{NUTZ} als Detaildarstellung aus Fig. 3.

Wie aus Fig. 3 und 4 ersichtlich ist, wertet die Auswerteschaltung 10 als Signalcharakteristik eine Entladekurve E des gepulsten Nutzsignal U_{NUTZ} aus, wobei der Verlauf E des Nutzsignal U_{NUTZ} einen ordnungsgemäßen Zustand der elektrischen Verbindung B repräsentiert. Das kapazitive Verhalten des Schaltungsteils 1 unterliegt einem Taktschema mit Auf- und Entladen. Dadurch ändert sich bei einer abgerissenen bzw. aufgetrennten elektrischen Verbindung B' die Entladekurve des Nutzsignals U_{NUTZ}, was zu einer gestrichelt dargestellten Fehlerkurve F führt.

Die Auswerteschaltung 10 erkennt eine abgerissene elektrische Verbindung B', wenn ein erfasster Spannungswert des gepulsten Nutzsignal U_{NUTZ}, welches in diesem Fall durch den gestrichelt dargestellten Verlauf des Fehlersignals F repräsentiert wird, zu einem Messzeitpunkt T_{M} oberhalb des vorgegebenen Schwellwerts S liegt. Die Auswerteschaltung 10 gibt dann als Testergebnis ein Signal aus, das diesen nicht ordnungsgemäßen Verbindungszustand niO (nicht in Ordnung) repräsentiert, beispielsweise durch Setzen eines Fehlerbits.

Im Gegensatz dazu erkennt die Auswerteschaltung 10 eine ordnungsgemäße elektrische Verbindung B, wenn ein erfasster Spannungswert des gepulsten Nutzsignal U_{NUTZ}, welches in diesem Fall durch den Verlauf der Entladekurve E repräsentiert wird, zu einem Messzeitpunkt T_{M} unterhalb des vorgegebenen Schwellwerts S liegt. Die Auswerteschaltung 10 gibt dann als Testergebnis ein Signal aus, das diesen ordnungsgemäßen Verbindungszustand iO (in Ordnung) repräsentiert.

Wie aus Fig. 4 ersichtlich ist, wählt die Auswerteschaltung 10 den Messzeitpunkt T_{M} so, dass ungefähr 80 bis 95%, vorzugsweise 90% einer Impulsdauer T_{I} eines korrespondierenden Auswerteimpulses des Nutzsignal U_{NUTZ} abgelaufen sind, da zu diesem Zeitpunkt der korrespondierende Lade bzw. Entladevorgang des kapazitiven Anteils C des Schaltungsteils 1 im Wesentlichen abgeschlossen ist.

Die Auswerteschaltung 10 kann das gepulste Nutzsignal U_{NUTZ} beispielsweise fortlaufend, zu vorgebbaren Zeitpunkten und/oder zyklisch erfassen bzw. auswerten.

Ausführungsformen des erfindungsgemäßen Verfahrens zur Verbindungsabrisserkennung an einem Schaltungsteil 1 mit kapazitivem Verhalten, welches elektrisch mit einer Nutzsignalquelle 3 verbunden ist, erfassen erfindungsgemäß am Eingangsknoten 5 des Schaltungsteils 1 mit kapazitivem Verhalten das von der Nutzsignalquelle 3 ausgegebene gepulste Nutzsignal U_{NUTZ} erfasst und werten die Signalcharakteristik zur Verbindungsabrisserkennung aus. Als Signalcharakteristik wird vorzugsweise eine Entladekurve E des gepulsten Nutzsignals U_{NUTZ} auswertet, wobei eine abgerissene Verbindung erkannt wird, wenn ein erfasster Spannungswert des gepulsten Nutzsignal U_{NUTZ} zum Messzeitpunkt T_{M} oberhalb des vorgegebenen Schwellwerts S liegt, und wobei eine ordnungsgemäße Verbindung erkannt wird, wenn der erfasste Spannungswert des gepulsten Nutzsignal U_{NUTZ} zu einem Messzeitpunkt T_{M} unterhalb des vorgegebenen Schwellwerts S liegt. Der Messzeitpunkt T_{M} wird vorzugsweise so wählt, dass der Lade bzw. Entladevorgang des kapazitiven Anteils C des Schaltungsteils 1 im Wesentlichen abgeschlossen ist. Das bedeutet, dass der Messzeitpunkt T_{M} auf einen Zeitpunkt gelegt wird, am welchem ungefähr 80 bis 95%, vorzugsweise 90% der Impulsdauer T_{I} eines korrespondierenden Auswerteimpulses des Nutzsignal U_{NUTZ} abgelaufen sind.

Das gepulste Nutzsignal U_{NUTZ} kann beispielsweise fortlaufend, zu vorgebbaren Zeitpunkten und/oder zyklisch erfasst bzw. das gepulste Nutzsignal U_{NUTZ} kann fortlaufend, zu vorgebbaren Zeitpunkten und/oder zyklisch zur Verbindungsabrisserkennung ausgewertet werden.

Ausführungsformen der vorliegenden Erfindung stellten eine Anordnung zur Verbindungsabrisserkennung an einem Schaltungsteil mit kapazitivem Verhalten zur Verfügung, welche in vorteilhafter Weise mit geringem Hardwareaufwand und ohne zusätzliche Signalgeneratoren zur Erzeugung von Testsignalen eine Anschlussüberwachung ermöglichen und damit eine große Lücke zu einem sicheren Betrieb schließen.

## Patentansprüche

1. Anordnung zur Verbindungsabrisserkennung an einem Schaltungsteil mit kapazitivem Verhalten, welches elektrisch mit einer Nutzsignalquelle (3) verbunden ist, umfassend eine Auswerteschaltung (10), welche mit einem Eingangsknoten (5) des Schaltungsteils (1) mit kapazitivem Verhalten elektrisch verbunden ist, **dadurch gekennzeichnet, dass** die Auswerteschaltung (10) ein von der Nutzsignalquelle (3) ausgegebenes gepulstes Nutzsignal (U_{NUTZ}) am Eingangsknoten (5) des Schaltungsteils (1) mit kapazitivem Verhalten erfasst und die Signalcharakteristik zur Verbindungsabrisserkennung auswertet, wobei die Auswerteschaltung (10) als Signalcharakteristik eine Entladekurve (E) des gepulsten Nutzsignals (U_{NUTZ}) auswertet.

2. Anordnung nach Anspruch 1, **dadurch gekennzeichnet, dass** die Auswerteschaltung (10) eine abgerissene elektrische Verbindung (B') erkennt, wenn ein erfasster Spannungswert des gepulsten Nutzsignals (U_{NUTZ}) zu einem Messzeitpunkt (T_{M}) oberhalb eines vorgegebenen Schwellwerts (S) liegt.

3. Anordnung nach Anspruch 1 oder 2, **dadurch gekennzeichnet, dass** die Auswerteschaltung (10) eine ordnungsgemäße elektrische Verbindung (B) erkennt, wenn der erfasste Spannungswert des gepulsten Nutzsignals (U_{NUTZ}) zu einem Messzeitpunkt (T_{M}) unterhalb des vorgegebenen Schwellwerts (S) liegt.

4. Anordnung nach Anspruch 2 oder 3, **dadurch gekennzeichnet, dass** die Auswerteschaltung (10) den Messzeitpunkt (T_{M}) so wählt, dass ungefähr 80 bis 95%, vorzugsweise 90% einer Impulsdauer (TI) eines korrespondierenden Auswerteimpulses des Nutzsignals (U_{NUTZ}) abgelaufen sind.

5. Anordnung nach einem der Ansprüche 1 bis 4, **dadurch gekennzeichnet, dass** die Auswerteschaltung (10) das gepulste Nutzsignal (U_{NUTZ}) fortlaufend, zu vorgebbaren Zeitpunkten und/oder zyklisch erfasst.

6. Verfahren zur Verbindungsabrisserkennung an einem Schaltungsteil mit kapazitivem Verhalten, welches elektrisch mit einer Nutzsignalquelle (3) verbunden ist, **dadurch gekennzeichnet, dass** an einem Eingangsknoten (5) des Schaltungsteils (1) mit kapazitivem Verhalten ein von der Nutzsignalquelle (3) ausgegebenes gepulstes Nutzsignal (U_{NUTZ}) erfasst und die Signalcharakteristik zur Verbindungsabrisserkennung ausgewertet wird, wobei als Signalcharakteristik eine Entladekurve (E) des gepulsten Nutzsignals (U_{NUTZ}) ausgewertet wird.

7. Verfahren nach Anspruch 6, **dadurch gekennzeichnet, dass** eine abgerissene elektrische Verbindung (B') erkannt wird, wenn ein erfasster Spannungswert des gepulsten Nutzsignals (U_{NUTZ}) zu einem Messzeitpunkt (T_{M}) oberhalb eines vorgegebenen Schwellwerts (S) liegt, und wobei eine ordnungsgemäße elektrische Verbindung (B) erkannt wird, wenn der erfasste Spannungswert des gepulsten Nutzsignals (U_{NUTZ}) zu einem Messzeitpunkt (T_{M}) unterhalb des vorgegebenen Schwellwerts (S) liegt.

8. Verfahren nach Anspruch 7, **dadurch gekennzeichnet, dass** der Messzeitpunkt (T_{M}) so wählt wird, dass ungefähr 80 bis 95%, vorzugsweise 90% einer Impulsdauer (TI) eines korrespondierenden Auswerteimpulses des Nutzsignals (U_{NUTZ}) abgelaufen sind.

9. Verfahren nach einem der Ansprüche 6 bis 8, **dadurch gekennzeichnet, dass** das gepulste Nutzsignal (U_{NUTZ}) fortlaufend, zu vorgebbaren Zeitpunkten und/oder zyklisch erfasst wird.

## Claims

1. Arrangement for detecting connection loss at a circuit part having a capacitive behaviour, which circuit part is electrically connected to a useful signal source (3), comprising an evaluating circuit (10) that is electrically connected to an input junction (5) of the circuit part (1) having a capacitive behaviour, **characterized in that** said evaluating circuit (10) senses a pulsed useful signal (U_{USEFUL}) that is output by the useful signal source (3) at the input junction (5) of the circuit part (1) having a capacitive behaviour and evaluates the signal characteristic for the purpose of detecting connection loss, wherein the evaluating circuit (10) evaluates as a signal characteristic a discharge curve (D) of the pulsed useful signal (U_{USEFUL}).

2. Arrangement according to Claim 1, **characterized in that** the evaluating circuit (10) recognizes a disconnected electrical connection (B') if a sensed voltage value of the pulsed useful signal (U_{USEFUL}) at a measuring point in time (T_{M}) exceeds a predetermined threshold value (TV).

3. Arrangement according to Claim 1 or 2, **characterized in that** the evaluating circuit (10) recognizes an intact electrical connection (B)if the sensed voltage value of the pulsed useful signal (U_{USEFUL}) at a measuring point in time (T_{M}) is below the predetermined threshold value (TV).

4. Arrangement according to Claim 2 or 3, **characterized in that** the evaluating circuit (10) selects the measuring point in time (T_{M}) so that approx. 80 to 95%, preferably 90% of a pulse duration (Tₗ) of a corresponding evaluating pulse of the useful signal (U_{USEFUL}) has elapsed.

5. Arrangement according to any one of Claims 1 to 4, **characterized in that** the evaluating circuit (10) senses the pulsed useful signal (U_{USEFUL}) continuously, at predeterminable points in time and/or in a periodic manner.

6. Method for detecting connection loss at a circuit part having a capacitive behaviour, which circuit part is electrically connected to a useful signal source (3), **characterized in that** a pulsed useful signal (U_{USEFUL}) that is output by the useful signal source (3) is sensed at an input junction (5) of the circuit part (1) having a capacitive behaviour and the signal characteristic is evaluated for the purpose of detecting connection loss, wherein a discharge curve (D) of the pulsed useful signal (U_{USEFUL}) is evaluated as a signal characteristic.

7. Method according to Claim 6, **characterized in that** a disconnected electrical connection (B')is recognized if a sensed voltage value of the pulsed useful signal (U_{USEFUL}) at a measuring point in time (T_{M}) exceeds a predetermined threshold value (TV) and wherein an intact electrical connection (B) is recognized if the sensed voltage value of the pulsed useful signal (U_{USEFUL}) at a measuring point in time (T_{M}) is below the predetermined threshold value (TV).

8. Method according to Claim 7, **characterized in that** the measuring point in time (T_{M}) is selected so that approx. 80 to 95%, preferably 90%, of a pulse duration (Tₗ) of a corresponding evaluating pulse of the useful signal (U_{USEFUL}) has elapsed.

9. Method according to any one of Claims 6 to 8, **characterized in that** the pulsed useful signal (U_{USEFUL}) is sensed continuously, at predeterminable points in time and/or in a periodic manner.

## Revendications

1. Arrangement de détection de rupture de liaison sur une pièce de commutation ayant un comportement capacitif, laquelle est reliée électriquement à une source de signal utile (3), comprenant un circuit d'interprétation (10) qui est relié électriquement à un noeud d'entrée (5) de la pièce de commutation (1) au comportement capacitif, **caractérisé en ce que** le circuit d'interprétation (10) détecte un signal utile (U_{NUTZ}) impulsionnel délivré par la source de signal utile (3) au niveau du noeud d'entrée (5) de la pièce de commutation (1) au comportement capacitif et interprète la caractéristique du signal en vue de reconnaître une rupture de liaison, le circuit d'interprétation (10) interprétant comme caractéristique du signal une courbe de décharge (E) du signal utile (U_{NUTZ}) impulsionnel.

2. Arrangement selon la revendication 1, **caractérisé en ce que** le circuit d'interprétation (10) reconnaît une liaison électrique rompue (B') lorsqu'une valeur de tension détectée du signal utile (U_{NUTZ}) impulsionnel à un instant de mesure (T_{M}) est supérieure à une valeur de seuil (S) prédéfinie.

3. Arrangement selon la revendication 1 ou 2, **caractérisé en ce que** le circuit d'interprétation (10) reconnaît une liaison électrique conforme aux règles (B) lorsque la valeur de tension détectée du signal utile (U_{NUTZ}) impulsionnel à un instant de mesure (T_{M}) est inférieure à la valeur de seuil (S) prédéfinie.

4. Arrangement selon la revendication 2 ou 3, **caractérisé en ce que** le circuit d'interprétation (10) sélectionne l'instant de mesure (T_{M}) de telle sorte qu'environ 80 à 95 %, de préférence 90 % d'une durée d'impulsion (TI) d'une impulsion d'interprétation correspondante du signal utile (U_{NUTZ}) se soient écoulés.

5. Arrangement selon l'une des revendications 1 à 4, **caractérisé en ce que** le circuit d'interprétation (10) détecte le signal utile (U_{NUTZ}) impulsionnel continuellement, à des instants pouvant être prédéfinis et/ou de manière cyclique.

6. Procédé de détection de rupture de liaison sur une pièce de commutation ayant un comportement capacitif, laquelle est reliée électriquement à une source de signal utile (3), **caractérisé en ce qu'**un signal utile (U_{NUTZ}) impulsionnel délivré par la source de signal utile (3) est détecté au niveau d'un noeud d'entrée (5) de la pièce de commutation (1) au comportement capacitif et la caractéristique du signal est interprétée en vue de reconnaître une rupture de liaison, la caractéristique du signal interprétée étant une courbe de décharge (E) du signal utile (U_{NUTZ}) impulsionnel.

7. Procédé selon la revendication 6, **caractérisé en ce qu'**une liaison électrique rompue (B') est reconnue lorsqu'une valeur de tension détectée du signal utile (U_{NUTZ}) impulsionnel à un instant de mesure (T_{M}) est supérieure à une valeur de seuil (S) prédéfinie, et une liaison électrique conforme aux règles (B) est reconnue lorsque la valeur de tension détectée du signal utile (U_{NUTZ}) impulsionnel à un instant de mesure (T_{M}) est inférieure à la valeur de seuil (S) prédéfinie.

8. Procédé selon la revendication 7, **caractérisé en ce que** l'instant de mesure (T_{M}) est sélectionné de telle sorte qu'environ 80 à 95 %, de préférence 90 % d'une durée d'impulsion (TI) d'une impulsion d'interprétation correspondante du signal utile (U_{NUTZ}) se soient écoulés.

9. Procédé selon l'une des revendications 6 à 8, **caractérisé en ce que** le signal utile (U_{NUTZ}) impulsionnel est détecté continuellement, à des instants pouvant être prédéfinis et/ou de manière cyclique.
